# EUROPÄISCHE PATENTANMELDUNG

(11) **EP 2 749 563 A1**
(43) Veröffentlichungstag der Anmeldung: **02.07.2014**
(21) Anmeldenummer: 13167032.5
(22) Anmeldetag: 08.05.2013
(51) Int. Cl.: C07F 1/08, H01L 51/50

(54) **Zweikernige Metall(I)-Komplexe für optoelektronische Anwendungen**

(30) Priorität: 27.12.2012 EP 12199403
(71) Anmelder: cynora GmbH, 76646 Bruchsal (DE)
(72) Erfinder: Volz, Daniel, 76137 Karlsruhe (DE); Jacob, Andreas, 76137 Karlsruhe (DE); Baumann, Thomas, 76131 Karlsruhe (DE); Grab, Tobias, 76133 Karlsruhe (DE)
(74) Vertreter: Hoppe, Georg Johannes

(57) **Zusammenfassung**

Die Erfindung betrifft Metall(I)komplexe der Formel A 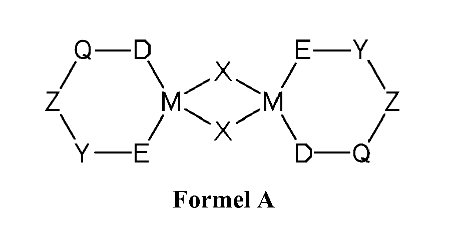 mit M = unabhängig voneinander ausgewählt aus der Gruppe bestehend aus Cu und Ag;
X = unabhängig voneinander ausgewählt aus der Gruppe bestehend aus Cl, Br, I, CN, OCN, SCN, Alkinyl und N₃;
E∩D = unabhängig voneinander ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen mit Substituenten wie Halogene oder Deuterium, Alkylgruppen, Heteroalkyl-, Aryl-, Heteroaryl und weitere allgemein bekannte Donor- und Akzeptor-Gruppen und CF₃-Gruppen;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen mit Substituenten wie Halogene oder Deuterium, Alkylgruppen, Heteroalkyl-, Aryl-, Heteroaryl und weitere allgemein bekannte Donor- und Akzeptor-Gruppen, und CF₃-Gruppen;
"∩" = eine dreiteilige Einheit aus Q, Y und Z, die miteinander verbunden sind und unabhängig voneinander ausgewählt sind aus der Gruppe bestehend aus NR, O, S und PR sowie Alkyl-, Heteroalkyl-, Aryl-, Heteroaryl-, Alkenyl-, Alkinyl-Gruppen bzw. substituierte Alkyl-, Heteroalkyl-, Aryl-, Heteroaryl- und Alkenyl-Gruppen mit Substituenten wie Halogene oder Deuterium, Alkylgruppen, Heteroalkyl-, Aryl-, Heteroaryl und weitere allgemein bekannte Donor- und Akzeptor-Gruppen, wie beispielsweise Amine, Carboxylate und deren Ester, und CF₃-Gruppen; sowie ihre Verwendung in optoelektronischen Bauelementen, insbesondere in OLEDs.

## Beschreibung

Die Erfindung betrifft zweikernige Metall(I)komplexe der allgemeinen Formel A, insbesondere zur Verwendung in optoelektronischen Bauelementen.

### Einleitung

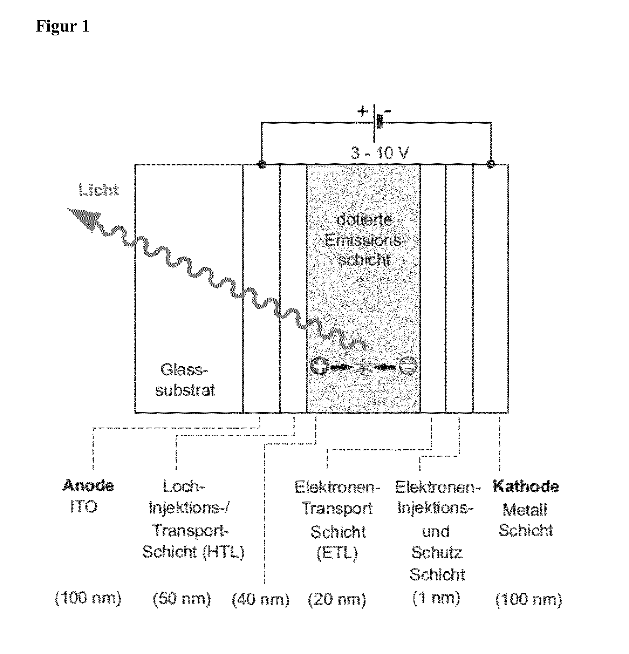

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLEDs,** den Organic Light Emitting Diodes, die in Figur 1 schematisch und vereinfacht dargestellt ist.

Derartige Bauteile bestehen vorwiegend aus organischen Schichten, wie in Figur 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.^{[i-vi]} Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.^{[i-v]} Für Triplett-Emitter wurden bereits viele Schutzrechte beantragt bzw. erteilt. ^{[vii-xix]}

Kupferkomplexe der Form Cu₂X₂L₄, Cu₂X₂L'₂ und Cu₂X₂L₂L' (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC *(cluster centered*)*-* oder XLCT (*halogen-to-ligand-charge-transfer*)-Zustand oder einer Kombination dieser stammen. Weitere Einzelheiten zu ähnlichen Cu(I)-Systemen können der Literatur entnommen werden.^{[xx]} Bei dem verwandten [Cu₂X₂(PPh₃)₂nap]-Komplex (nap = 1,8-Naphthyridin, X = Br, I) wird ein Übergang zwischen dem Molekülorbital der {Cu₂X₂}-Einheit (Cu d und Halogen p-Orbitale) und den π*-Orbitalen der nap-Gruppe diskutiert.^{[xxi]}

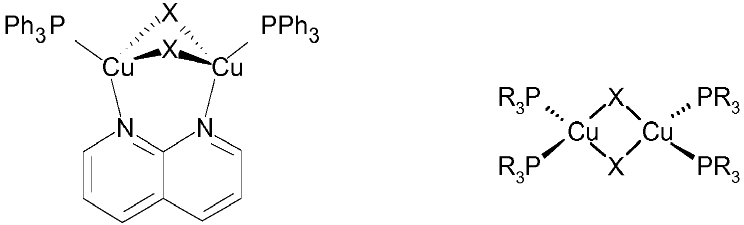

Beispiel einer Struktur der Komplexe der Form Beispiele der Komplexe der Form Cu₂X₂L₄ (L = Cu₂X₂L₂L' (L = PPh₃, L' = 1,8-Naphthyridin, X PR₃, X = Cl, Br, oder I)
= Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:
● Langzeitstabilität der Emitter in den OLED-Devices,
● Thermische Stabilität,
● Chemische Stabilität gegenüber Wasser und Sauerstoff,
● Verfügbarkeit wichtiger Emissionsfarben,
● Fertigungstechnische Reproduzierbarkeit,
● Erreichbarkeit einer hohen Effizienz bei hohen Stromdichten,
● Erreichbarkeit sehr hoher Leuchtdichten,
● Hoher Preis der Emittermaterialien,
● Emittermaterialien sind toxisch und
● Synthesen sind aufwendig.

Vor diesem Hintergrund lag der vorliegenden Erfindung die Aufgabe zu Grunde, zumindest einige der oben genannten Nachteile zu überwinden.

### Beschreibung der Erfindung

Das der Erfindung zu Grunde liegende Problem wird durch die Bereitstellung von zweikernigen Metall(I)komplexen der Form M₂X₂(E∩D)₂ gelöst, die eine Struktur gemäß Formel A umfassen oder von einer Struktur nach Formel A sind:

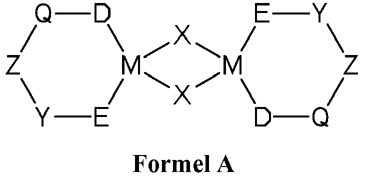

In Formel A (nachfolgend auch als M₂X₂(E∩D)₂ bezeichnet) steht E∩D unabhängig voneinander für einen zweizähnigen chelatisierenden Liganden, der über ein Donoratom D* und ein Donoratom E*, die unabhängig voneinander ausgewählt sind aus der Gruppe bestehend aus N, wobei N kein Imin-Stickstoffatom oder Teil eines N-heteroaromatischen Rings ist, P, C*, O, S, As und Sb an den M₂X₂-Kern bindet, wobei die beiden Donoratome D* und E* durch die drei Einheiten Q, Y, Z verbunden sind und somit einen zweizähnigen Liganden ergeben, und wobei in einer bevorzugten Ausführungsform nur die folgenden Kombinationen aus D* und E* zulässig sind:

| | | | | | | | | | | | | | | |
|---|---|---|---|---|---|---|---|---|---|---|---|---|---|---|
| D* = | N | N | P | S | S | C* | C* | C* | N* | P* | As* | S* | C* | C* |
| E* = | P | N | P | N | S | P | N | S | As* | As* | As* | As* | As* | C* |

In einer Ausführungsform der Erfindung ist die Kombination aus P und S für D* und E* ausgeschlossen. X steht unabhängig voneinander für Cl, Br, I, CN, OCN, SCN, Alkinyl und/oder N₃, M steht unabhängig voneinander für Cu und Ag. C* steht für ein divalentes Carben-Kohlenstoffatom. Bei ∩ handelt es sich um eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. Beide Liganden E∩D können auch weiter substituiert und/oder anneliert und/oder auch miteinander verbunden sein, so dass sich ein vierzähniger Ligand ergibt.

Q ist sowohl mit D als auch mit Z verbunden, wobei eine erste Bindung zwischen einem Atom Q* des Substituenten Q und einem Atom D* des Substituenten D ausgebildet wird, und wobei eine zweite Bindung zwischen einem Atom Q* des Substituenten Q und einem Atom Z* des Substituenten Z ausgebildet wird. Analoges gilt für Y, eine erste Bindung wird zwischen einem Atom Y* des Substituenten Y und einem Atom E* des Substituenten E ausgebildet, und eine zweite Bindung zwischen einem Atom Y* des Substituenten Y und einem Atom Z* des Substituenten Z ausgebildet. Analoges gilt für Z, eine erste Bindung wird zwischen einem Atom Z* des Substituenten Z und einem Atom Q* des Substituenten Q* ausgebildet, und eine zweite Bindung zwischen einem Atom Z* des Substituenten Z und einem Atom Y* des Substituenten Y ausgebildet. Q*, Y* und Z* sind unabhängig voneinander ausgewählt aus der Gruppe bestehend aus C, N, O, S und P.

Jedes R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Der Ligand E∩D kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Spezielle Ausführungsformen der erfindungsgemäßen zweikernigen Metall(I)komplexe der Formel A werden durch die Verbindung der Formeln I bis IX dargestellt und im Folgenden erläutert. 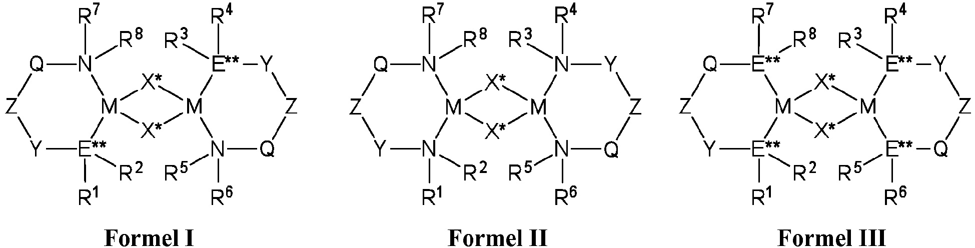 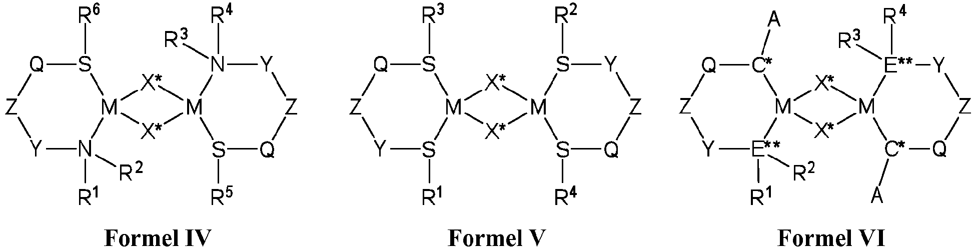 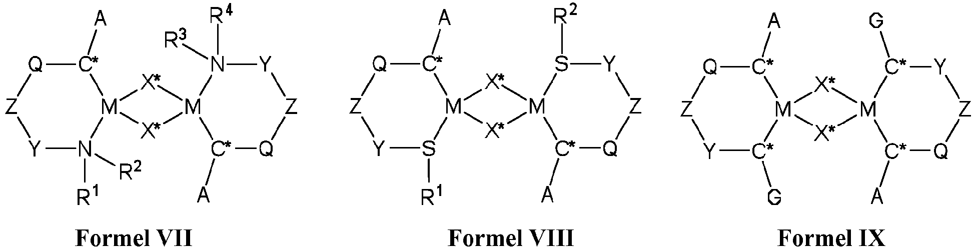 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. Die Reste R¹-R⁸ können optional auch zu annelierten Ringsystemen führen.

Die Einheit QC*A ist in einer Ausführungsform ausgewählt aus der Gruppe bestehend aus: 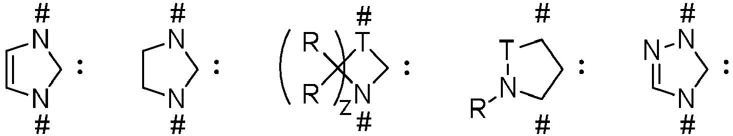 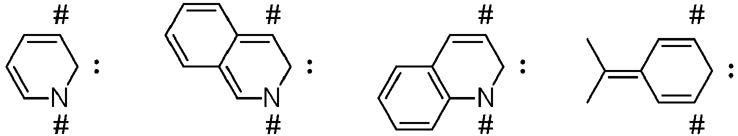 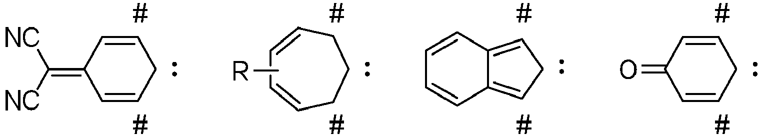 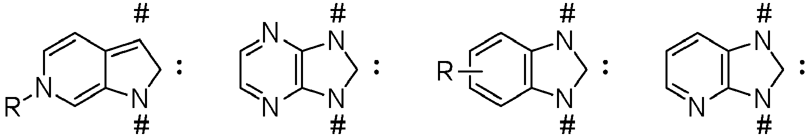 wobei die zwei Punkte ":" für ein divalentes Carben-Kohlenstoffatom stehen, das an das Metall koordiniert, und die Verknüpfung von Q mit Z an einer der mit # gekennzeichneten Stellen stattfindet und somit A das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R ist unabhängig voneinander ebenfalls ausgewählt aus der Gruppe bestehend aus Wasserstoff, Halogen und Substituenten, die direkt oder über Sauerstoff- (-OR), Stickstoff- (-NR₂),
(auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
und z für die ganzen Zahlen 1, 2, 3 oder 4 steht.

Der zweizähnige Ligand E∩D kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Ein erfindungsgemäßer Metall(I)komplex besteht bevorzugt aus einem zweizähnigen Liganden E∩D, wodurch die Stabilität und Rigidität des Metall(I)komplexes stark erhöht wird. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Metall(I)komplexe durch einen weiten Bereich von erzielbaren

Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Metall(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden E∩D in den Formeln I bis IX um folgende Liganden: 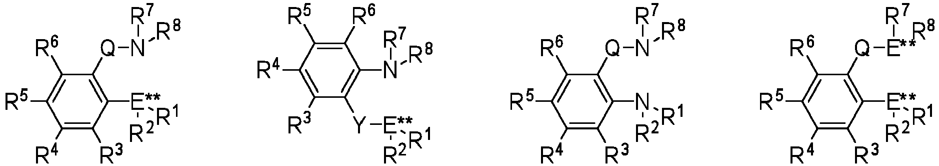 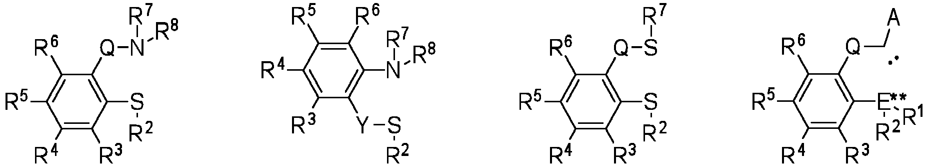 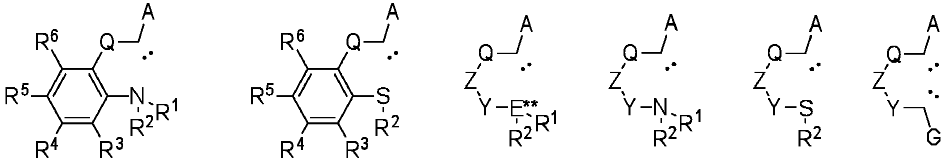 mit
E** = unabhängig voneinander ausgewählt ist aus der Gruppe bestehend aus P, As und Sb,
: = ein Carben-Kohlenstoffatom,
A und G = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
A und Q und G und Y können optional jeweils miteinander verbunden sein, sodass sich ein Imidazolidin- oder ein Imidazolderivat ausbildet und/oder mit der Einheit Z und/oder den Resten R³-R⁸ auch zu annelierten Ringsystemen führen,
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR)gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. R³-R⁸ können optional auch zu annelierten Ringsystemen führen.

Der zweizähnige Ligand E∩D kann an geeigneten Stellen mit mindestens einer Funktions-Gruppe FG substituiert sein. So können sich direkte C_{FG}-C_{E∩D} Bindungen bilden, wobei C_{E∩D} ein C-Atom des E∩D Liganden darstellt und C_{FG} ein C-Atom der Funktions-Gruppe. Ist das anbindende Atom ein Stickstoffatom, so ergeben sich N_{FG}-C_{E∩D} Bindungen, wobei N_{FG} für das Stickstoffatom steht. Andererseits kann die Funktions-Gruppe über eine Brücke an den E∩D Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{E∩D}, C_{FG}-S-C_{E∩D}, C_{FG}-C(O)-O-C_{E∩D}, C_{FG}-C(O)-NH-C_{E∩D}, C_{FG}-CH₂-C_{E∩D}, C_{FG}-SiR'₂-C_{E∩D}C_{N*∩E}, C_{FG}-CH=CH-C_{E∩D}, C_{FG}-C≡C-C_{E∩D}, N_{FG}-CH₂-C_{E∩D}.

Die Verfahren zur Verknüpfung der Funktionsgruppe an den E∩D Ligand, entweder direkt oder über eine Brücke, sind dem Fachmann bekannt (Suzuki-, Still-, Heck-, Sonogashira-, Kumada-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R auch ein elektronenleitender, lochleitender oder die Löslichkeit erhöhender Substituent sein.

Die Erfindung betrifft auch ein Verfahren zur Herstellung eines erfindungsgemäßen Metall(I)komplexes. Dieses erfindungsgemäße Verfahren weist den Schritt des Durchführens einer Reaktion des zweizähnigen Liganden E∩D mit M(I)X auf,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl und N₃,
E∩D = ein zweizähniger Ligand mit

E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. R ist unabhängig voneinander ausgewählt aus der Gruppe bestehend aus Wasserstoff, Halogen und Substituenten, die direkt oder über Sauerstoff-(-OR), Stickstoff- (-NR₂), Silizium- (-SiR₃) oder Schwefelatome (-SR) gebunden sind sowie Alkyl-(auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Der optional am Liganden E∩D vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen E∩D-Liganden mit M(I)X (M = Ag, Cu; X = Cl, Br, I), bevorzugt in Dichlormethan (DCM), bevorzugt bei Raumtemperatur, entsteht der zweikernige 2:2-Komplex Cu₂X₂(E∩D)₂, in dem jedes Cu-Atom durch je einen Liganden zweifach koordiniert sowie die beiden Halogenid-Anionen überbrückt wird (Gl. 1).

Die Struktur der Formel A ist verwandt mit bekannten Komplexen der Form Cu₂X₂L₂L' bzw. Cu₂X₂L₄. Im Gegensatz zu Cu₂X₂L₄ mit vier einzähnigen Liganden L (L = PR₃ oder Pyridin, X = Cl, Br, oder I) ist die Stabilität des hier beschriebenen Komplexes durch Verwendung von zwei zweizähnigen Liganden der Form E∩D viel größer (erkennbar beispielsweise durch Absorptions - und Emissionsmessungen des Komplexes in Lösung und als Filme) und zusätzlich die Rigidität des Komplexes stark erhöht. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

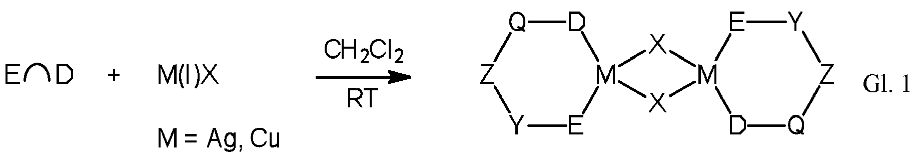

Hierbei handelt es sich um die oben aufgeführte allgemeine Formel A. Der zweizähnige E∩D-Ligand kann mindestens einen Rest R umfassen, der jeweils unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl - und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor - und Akzeptor-Gruppen, wie beispielsweise Amine, Carboxylate und deren Ester, und CF₃-Gruppen. Die Substituenten können auch zu anellierten Ringsystemen führen.

### Substituenten zur Einführung unterschiedlicher Funktionalitäten

Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports können entweder einfach oder mehrfach am E∩D-Liganden gebunden sein. Es können identische oder unterschiedliche Funktions-Gruppen verwendet werden. Die Funktions-Gruppen können symmetrisch oder unsymmetrisch vorhanden sein.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumada-, Ullmann-, Buchwald-Hartwig-Kupplung sowie deren Varianten zu Einsatz.

Dabei geht man von einem mit Halogenid (Cl, Br, I), insbesondere Br, substituierten E∩D-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und E∩D-Ligand. Bei Anwesenheit von -OH Gruppen kommen hier z. B. Veresterungen und Etherbildung in Frage, bei -NH₂ Gruppen Imin - und Amidbildung, bei -COOH Gruppen Esterbildung. Entsprechend muss das Subsitutionsmuster des E∩D-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

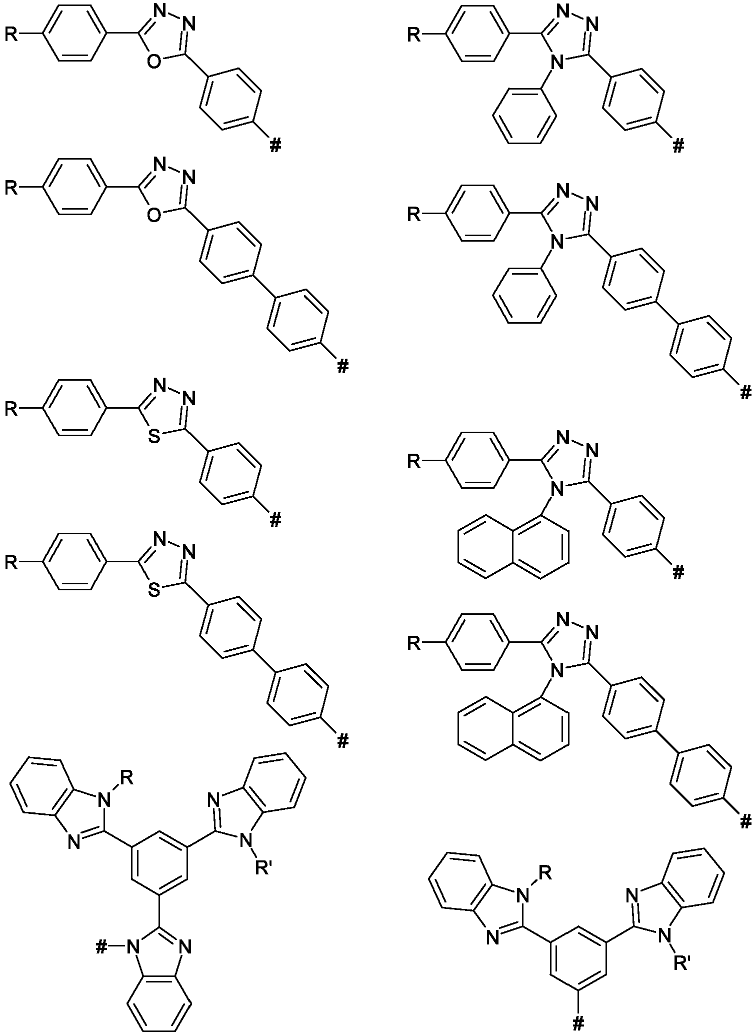

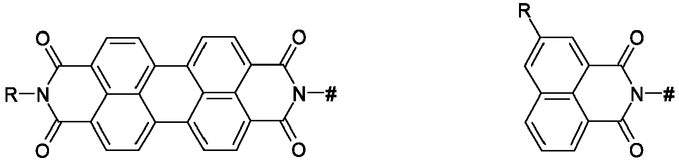

Bei den Substituenten R und R' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR"'₃) oder Ethergruppen -OR"' (R"' definiert wie R; die hier verwendeten Substituenten entsprechen nicht notwendiger Weise den Substituenten R und/oder R' der Formel A oder der Formeln I bis IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den E∩D-Liganden am einfachsten durch Palladiumkatalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

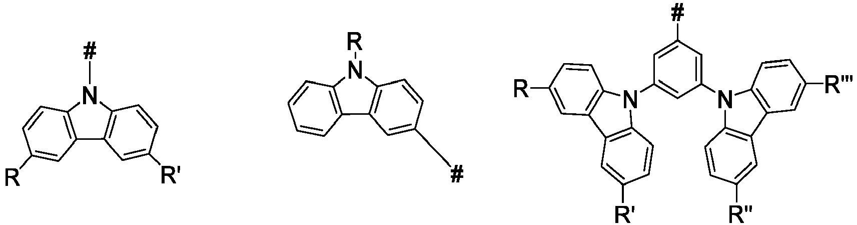

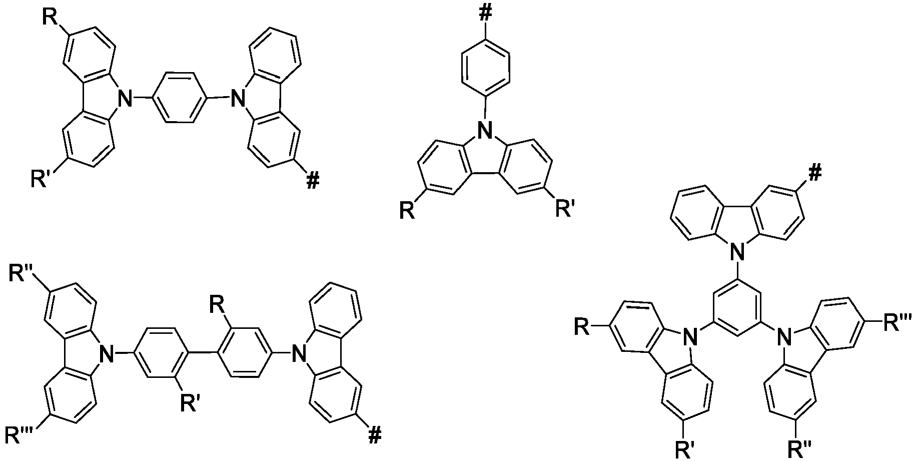

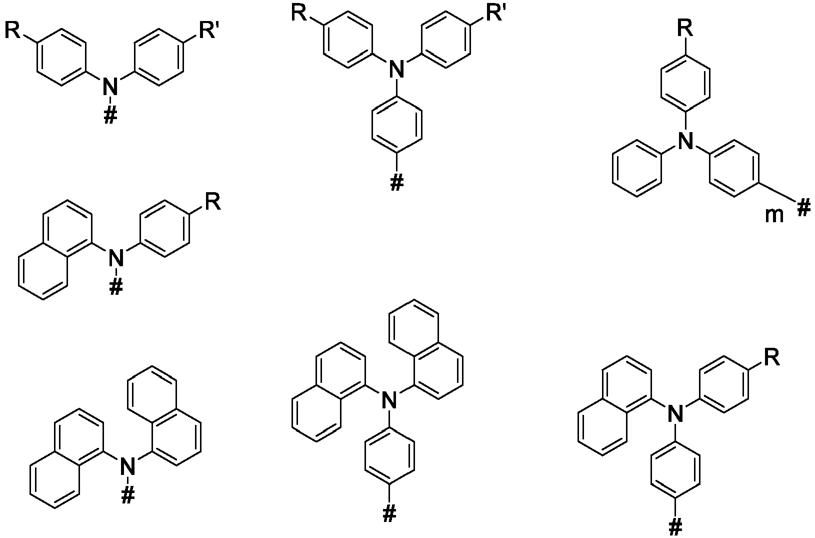

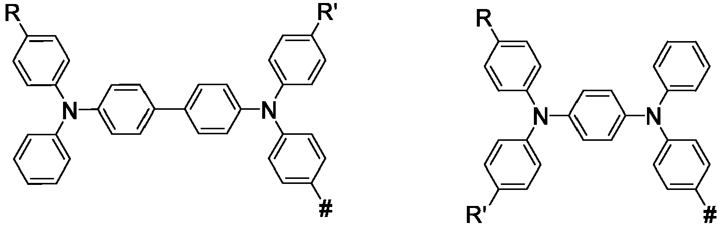

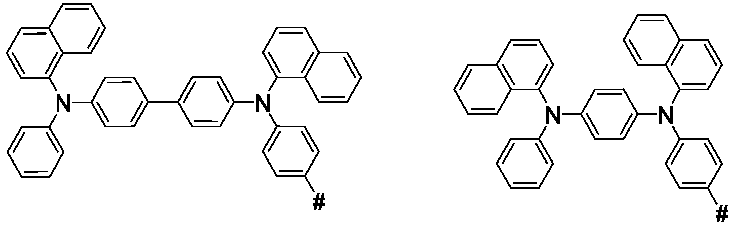

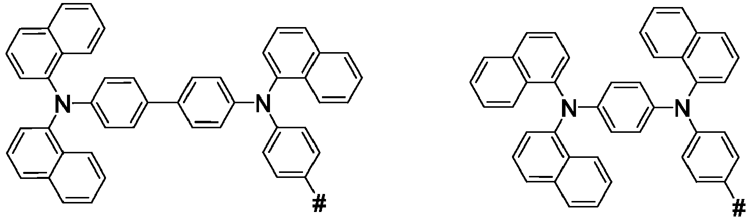

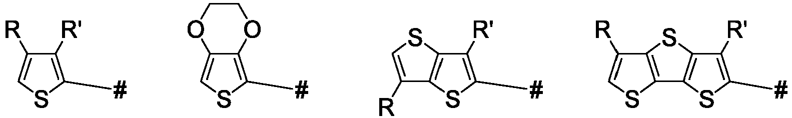

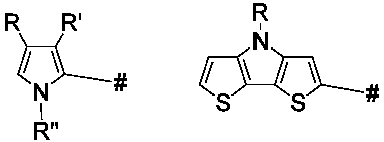

Bei den oben gezeigten Substituenten R, R" und R"' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""₃) oder Ethergruppen -OR"" (R"" definiert wie R; die oben für die Lochtransport-Substituenten verwendeten Substituenten entsprechen nicht notwendiger Weise den Substituenten R und/oder R' der Formel A oder der Formeln I bis IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

Zur Verwendung der Metall(I)-Komplexe als selbstkatalysierende Emittermaterialien zur Erzielung einer Quervernetzung mit einem zweiten Reaktanden können solche Funktionalitäten in der Peripherie des E∩D-Liganden angebracht werden, die mit der entsprechend komplementären funktionellen Einheit des zweiten Reaktanden eine durch den Metall(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

Beispielhaft für eine selbstkatalysierte Quervernetzungsreaktion ist die Kupfer-katalysierte Click-Reaktion zwischen einem terminalen oder aktivierten Alkin als erster Click-Gruppe und einem Azid als zweiter Click-Gruppe. Da der Metallkomplex-Emitter mindestens zwei Alkin-Einheiten tragen muss, sind mindestens zwei der Strukturen E∩D in bevorzugter Weise mit mindestens je einer der oben genannten funktionellen Gruppe zur Erzielung einer Quervernetzung substituiert, während die für die Quervernetzung nicht aktive Struktur E∩D optional mit einer anderen der oben genannten funktionellen Gruppe zur Erhöhung der Löslichkeit des Komplexes in organischen Lösungsmitteln und/oder zur Verbesserung des Ladungsträgertransports substituiert sein kann.

Somit können unterschiedliche Funktionalitäten über die Peripherie der verschiedenen Liganden eingeführt werden (beispielsweise je eine Lochtransport- und Elektrontransport-Einheit zur Erzielung eines optimalen Ladungsträgertransports und/oder ein Substituent zur Erhöhung der Löslichkeit des Komplexes in organischen Lösungsmitteln und/oder eine funktionelle Gruppe zur Erzielung einer Quervernetzung), wodurch eine sehr flexible Anpassung und Modifizierung der Metall(I)-Komplexe möglich ist.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R¹-R⁸ so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R¹-R⁸ erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ- (n = 2 - 500). Weitere unpolare Gruppen sind: Ether -OR*, Thioether -SR*, unterschiedlich substituierte Silane R*₃Si-(R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O)ₙ- (n > 20); Oligo/polyphosphazene R**(-R*₂P=N-)ₙ- (n = 1 - 200).

### Löslichkeit in polaren Medien

Polare Substitutenten R¹-R⁸ erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze): -COOH, -P(O)(OH)₂ , -P(S)(OH)₂ , -S(O)(OH)₂ , -COOR*, -P(O)(OR*)₂, -P(S)(OR*)₂ ,-S(O)(OR*)₂ , -CONHR*, -P(O)(NR*₂)₂ , -P(S)(NR*₂)₂ , -S(O)(NR*₂)₂
- Sulfoxide: -S(O)R*, -S(O)₂R*
- Carbonylgruppen: -C(O)R*
- Amine: -NH₂ , -NR*₂ , -N(CH₂CH₂OH)₂ ,
- Hydroxylamine =NOR*
- Oligoester, -O(CH₂O-)ₙ , -O(CH₂CH₂O-)ₙ (n = 2 - 200)
- Positiv geladene Substituenten: z. B. Ammonium-Salze -N⁺R*₃X⁻ , Phosphonium-Salze - P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Optional kann das Darstellungsverfahren den Schritt umfassen, dass mindestens ein Ligand E∩D mit mindestens einem der oben genannten Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass mindestens ein Ligand E∩D mit mindestens einer der o. g. funktionellen Gruppe zur Verbesserung des Ladungsträgertransports substituiert wird, wobei die funktionelle Gruppe an einem Ligand E∩D gleich oder verschieden sein kann von der funktionellen Gruppe am anderen Ligand, bevorzugt verschieden, wobei der Substituent in einer Ausführungsform der Erfindung ausgewählt sein kann aus der Gruppe bestehend aus Elektronenleiter und Lochleiter.

Erfindungsgemäß sind auch Metall(I)komplexe, die durch ein derartiges Syntheseverfahren herstellbar sind.

Die Metall(I)komplexe der Formel A können erfindungsgemäß als Emitter-Materialien in einer Emitterschicht eines Licht-emittierenden optoelektronischen Bauelements eingesetzt werden.

Die Metall(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Metall(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Metall(I)komplexes in der Emitter- oder Absorber-Schicht 1 % bis 99 %.

Vorteilhafter Weise beträgt die Konzentration des Metall(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen Metall(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Metall(I)komplex der hier beschriebenen Art verwendet wird. Bei diesem Verfahren wird insbesondere ein erfindungsgemäßer Metall(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Metall(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Metall(I)komplex ein erfindungsgemäßer Metall(I)komplex ist. Erstes und zweites Lösungsmittel sind dabei nicht identisch.

Die vorliegende Erfindung betrifft auch ein Verfahren zur Veränderung der Emissions- und/oder Absorptionseigenschaften eines elektronischen Bauelements. Dabei wird ein erfindungsgemäßer Metall(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Metall(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Metall(I)komplex.

Da die erfindungsgemäßen Metall(I)komplexe mit unsubstituierten Liganden E∩D in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan-, Arsan- oder Antimon-Liganden unter diesen Bedingungen nicht ausgeschlossen werden. Daher ist nicht klar, ob die Substanzen bei einer Abscheidung auf dem Substrat als M₂X₂(E∩D)₂ kristallisieren bzw. ob sie in der Matrix in dieser Form molekular vorliegen werden. Aus diesem Grund sollten die Substanzen in einer für die Anwendung in optoelektronischen Bauelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Metall(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Metall(I)komplexe (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Um die Löslichkeit der erfindungsgemäßen Metall(I)komplexe in organischen Lösungsmitteln zu verbessern, ist mindestens eine der Strukturen E∩D in bevorzugter Weise mit mindestens einem der oben genannten Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ , mit n < 500. Beispiele hierfür sind Polyethylenglykole (PEG), die als chemisch inerte, wasserlösliche und nicht-toxische Polymere mit einer Kettenlänge von 3 bis 50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C3-Einheit, verzweigt oder unverzweigt oder zyklisch, erreicht.

Um den Ladungsträgertransport zu den erfindungsgemäßen Metall(I)komplexen zu verbessern, ist mindestens eine der Strukturen E∩D in bevorzugter Weise mit mindestens einer der oben genannten funktionellen Gruppe zur Verbesserung des Ladungsträgertransports substituiert, wobei die funktionelle Gruppe an einem Ligand E∩D gleich oder verschieden sein kann von der funktionellen Gruppe am anderen Ligand, bevorzugt verschieden. Der Substituent kann ausgewählt sein aus der Gruppe bestehend aus Elektronenleiter und Lochleiter.

Die Substituenten der Strukturen E∩D der Metall(I)komplexe können an jeder Stelle der Struktur angeordnet sein.

Ein weiterer Aspekt der Erfindung betriff die Veränderung der Emissionsfarben der Metall(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
- Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)₂, -S-Alkylgruppe

Beispiele für elektronenziehende Substituenten sind insbesondere:
- Halogen, -(CO)H, -(CO)-Alkylgruppe, -(CO)O-Alkylgruppe, -(CO)OH, -(CO)Halogenid, -CF₃, -CN, -SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt.

Somit kann durch geeignete Substitutionswahl innerhalb der Grundstruktur eines E∩D-Liganden ein sehr breiter Emissionsfarbbereich eingestellt werden.

Die Veränderung der Emissionsfarben der hier beschriebenen Metall(I)komplexe kann auch durch weitere Heteroatome wie N, O, S, sowie mittels kondensierter Aromaten erfolgen.

Die Verwendung kondensierter Aromaten wie beispielsweise Naphthyl, Anthracenyl, Phenanthrenyl etc. ermöglicht Farbverschiebungen, zum Beispiel in den gelben bis tiefroten Spektralbereich. Die Erhöhung der Löslichkeit von Metall(I)komplexen mit kondensierten Aromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Metall(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von den Koordinationsstellen des Liganden E∩D.

Ausgehend von einem geeigneten Synthesebaustein A werden in analogen Reaktionen unterschiedliche Reaktanden B, C und D unter analogen Reaktionsbedingungen zu chemisch diversen Zielmolekülen AB, AC und AD verknüpft. Hierdurch lassen sich beispielsweise unterschiedlich lange Alkylketten durch Verwendung nukleophiler Substitutionsreaktionen modular an einen geeigneten E∩D-Liganden anbringen

Für die Herstellung der oben genannten Nanopartikel kleiner als 30 nm können mehrere Techniken angewandt werden:^{[xxii]}

*Bottom-Up-Prozesse* zur Synthese von Nanopartikeln:
● schnelle Injektion der Reaktionslösung in einen großen Überschuss eines geeigneten Fällungsmittel (z. B. Pentan, Diethylether).^{[xxiii]}
● Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
● Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
● Co-Abscheidung der Komplexe und des Matrixmaterials auf dem Substrat direkt aus der Reaktionslösung.
● Synthese im Ultraschall-Bad.

Top-Down-Prozesse zur Zerkleinerung der Substanzen:
● Zerkleinerung durch Hochenergiekugelmühlen. ^{[xxiv]}
● Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen auch als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

### Figuren

- **Figur 1:**: Prinzipieller Aufbau eines OLEDs. Die Abbildung ist nicht maßstabsgerecht gezeichnet.
- **Figur 2:**: Festkörperstruktur von **1b.**
- **Figur 3:**: Emissionsspektrum einer festen, kristallinen Probe von **1a** (Anregung bei 350 nm).
- **Figur 4:**: Emissionsspektrum einer festen, kristallinen Probe von **1b** (Anregung bei 350 nm).
- **Figur 5:**: Emissionsspektrum einer festen, kristallinen Probe von **1c** (Anregung bei 350 nm).
- **Figur 6:**: Berechnete Grenzorbitale des Grundzustands von **1b.**
- **Figur 7:**: Emissionsspektrum einer festen, kristallinen Probe von **2a** (Anregung bei 350 nm).
- **Figur 8:**: Emissionsspektrum einer festen, kristallinen Probe von **2b** (Anregung bei 350 nm).
- **Figur 9:**: Emissionsspektrum einer festen, kristallinen Probe von **2c** (Anregung bei 350 nm).
- **Figur 10:**: Emissionsspektrum einer festen, kristallinen Probe von **2d** (Anregung bei 350 nm).

### Beispiele

In den hier gezeigten Beispielen ist der zweizähnige E∩D-Ligand der allgemeinen Formel A ein Amin-Phosphinligand (mit E = PPh₂ und D = NMe₂ bzw. E = PPh₂ und D = N(CH₂)₄), ein Bisaminligand (mit E und D = NMe₂), ein Bisphosphinligand (mit E und D = PPh₂), ein Amin-Thioetherligand (mit E = SPh und D = NMe₂), ein Bisthioetherligand (mit E und D = SPh), ein Phosphin-Carbenligand (mit E = PPh₂ und D = C*), ein Amin-Carbenligand (mit E = NMe₂ und D = C*) oder ein Thioether-Carbenligand (mit E = SPh und D = C*).

Die gestrichelt gezeichnete Doppelbindung im Carbenliganden bedeutet, dass entweder nur eine Einfachbindung vorliegt und somit ein Imidazolidin-Carben verwendet wird, oder dass alternativ eine Doppelbindung vorliegt und somit ein Imidazol-Carben eingesetzt wird.

Die Identitäten und Strukturen der Komplexe 1 bis 12 wurden eindeutig durch NMR-Spektroskopie, Massenspektrometrie, Elementaranalysen und/oder Kristallstrukturanalysen belegt.

### Beispiele für Komplexe der Form M₂X₂(E∩D)₂

### I. E∩D = Ph₂PMe₂NBenzyl, X = Cl, Br, I: Cu₂Cl₂(Ph₂PMe₂NBenzyl)₂ (1a), Cu₂Br₂(Ph₂PMe₂NBenzyl)₂ (1b), Cu₂I₂(Ph₂PMe₂NBenzyl)₂ (1c)

Bei den Verbindungen **1a-c** handelt es sich um gelbe, feinkristalline Feststoffe.

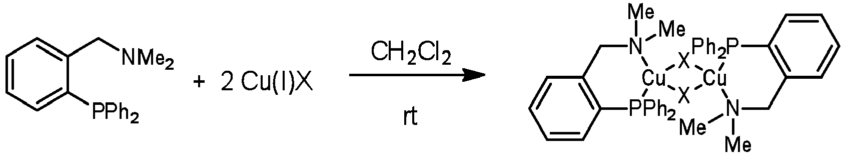

Charakterisierung:
Elementaranalyse:
   **1a:** ber.: C 60.29; H 5.30, N 3.35
      gef.: C 60.10; H 5.51, N 3.12
   **1b:** ber.: C 54.50; H 4.79; N 3.03
      gef.: C 54.53; H 4.90; N 2.87
   **1c:** ber.: C 49.47; H 4.35; N, 2.75
      gef.: C 49.30; H 4.35; N 2.56

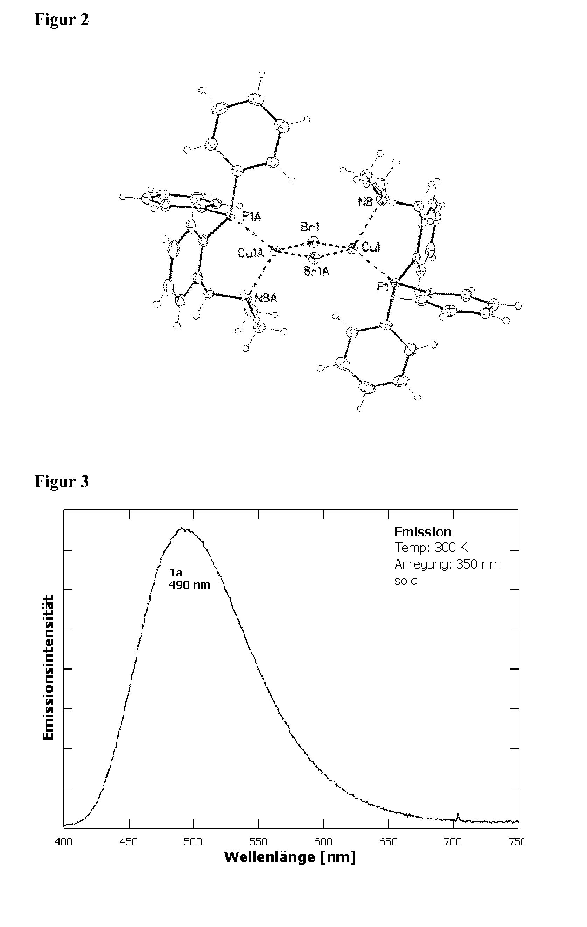

Die Kristallstruktur ist in Fig. 2 **(1b)** dargestellt.

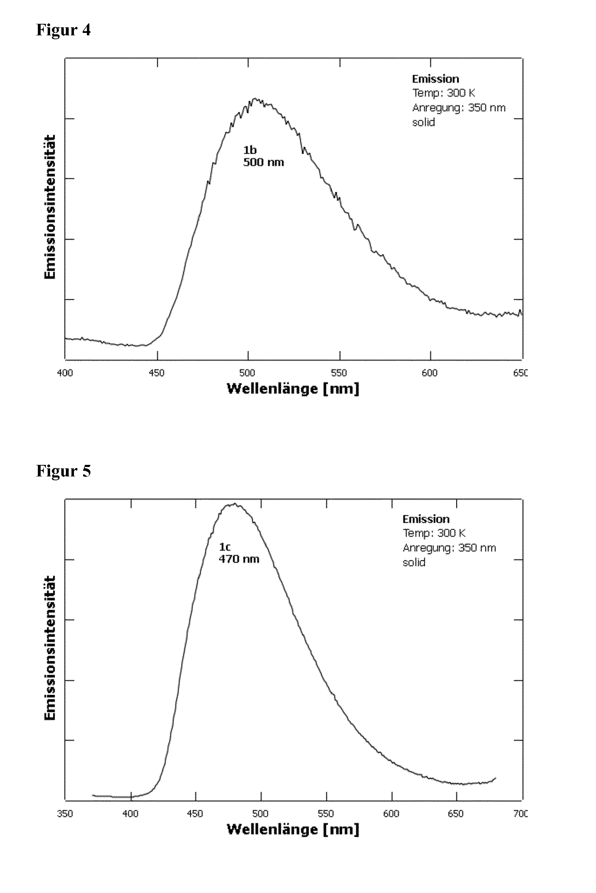

Die Emissionsspektren von **1a - 1c** sind in den Fig. 3 - 5 gezeigt.

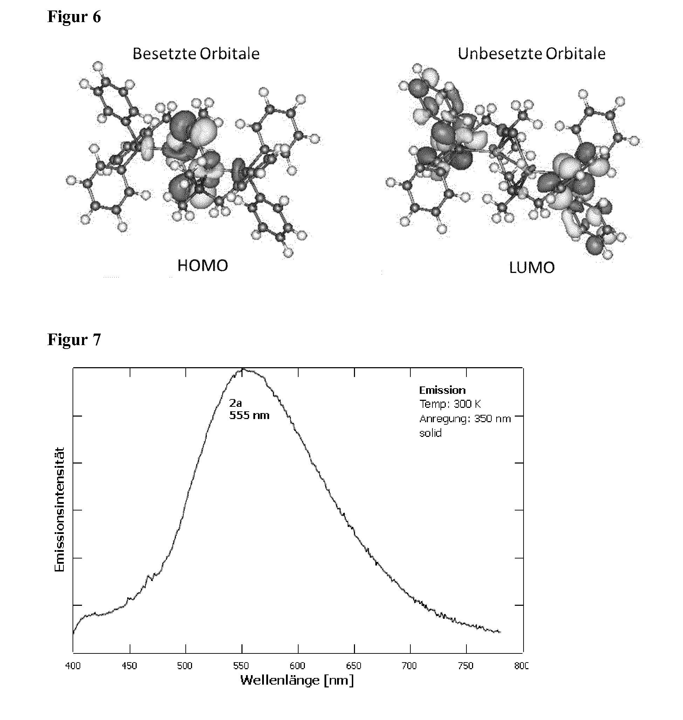

Die berechneten Grenzorbitale des Grundzustands von **1b** sind in Fig. 6 gezeigt.

### II. E∩D = Ph₂PMe₂NNaphtyl, X = Cl, Br, I, CN: Cu₂Cl₂(Ph₂PMe₂NNaphtyl)₂ (2a), Cu₂Br₂(Ph₂PMe₂NBenzyl)₂ (2b), Cu₂I₂(Ph₂PMe₂NBenzyl)₂ (2c), Cu₂CN₂(Ph₂PMe₂NBenzyl)₂ (2d),

Bei den Verbindungen **2a-d** handelt es sich um weiße, feinkristalline Feststoffe.

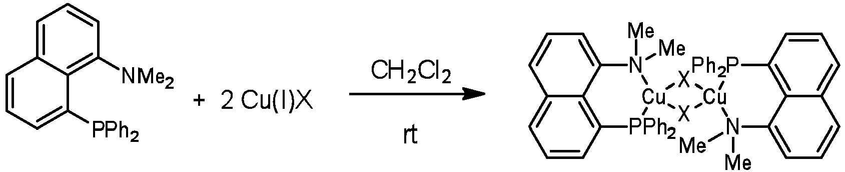

Charakterisierung:
Elementaranalyse:
   **2a:** Summenformel: C₄₈H₄₄Cl₂Cu₂N₂P₂ · ½ H₂O
      ber.: C 62.20; H 5.00; N 3.02
      gef.: C 62.02; H 4.71; N 2.87
   **2b:** Summenformel: C₄₈H₄₄Br₂Cu₂N₂P₂
      ber.: C 57.78; H 4.45; N 2.81
      gef.: C 57.61; H 4.36; N 2.64
   **2c:** Summenformel: C₄₈H₄₄Cl₂Cu₂N₂P₂
      ber.: C 52.81; H 4.06; N 2.57
      gef.: C 52.60; H 3.93; N 2.34
   **2d:** Summenformel: C₅₀H₄₄Cu₂N₄P₂ · ½ H₂O
      ber.: C 66.14; H 5.11; N 6.17
      gef.: C 65.72; H 4.76; N 6.57

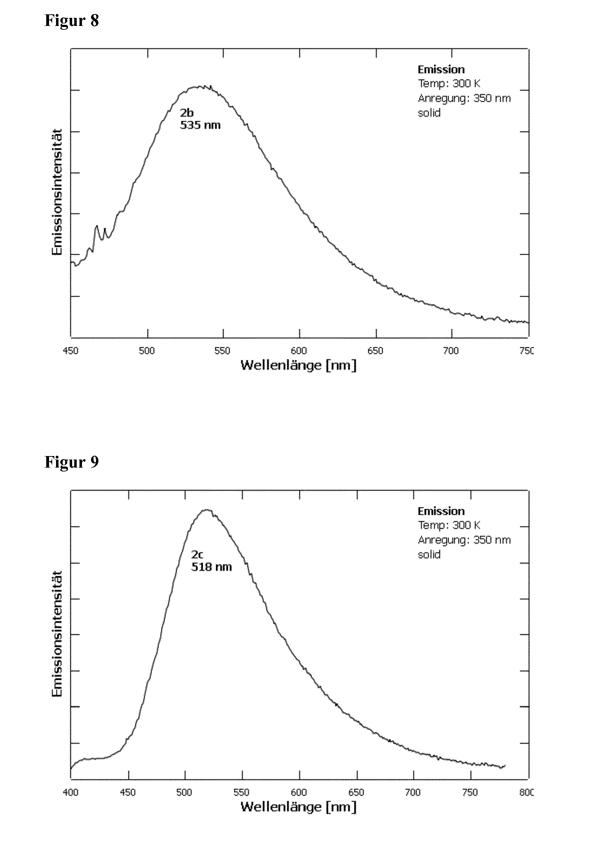

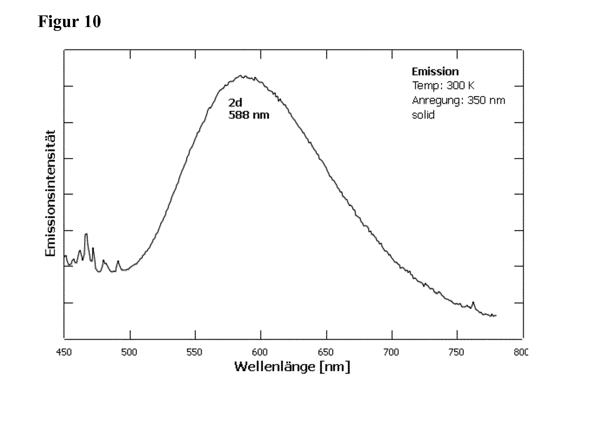

Die Emissionsspektren von **2a - 2d** sind in den Fig. 7 - 10 gezeigt.
**III. E∩D = Ph₂POMe₂NPhenyl, X = Cl, Br, I: Cu₂Cl₂(Ph₂POMe₂NPhenyl)₂ (3a), Cu₂Br₂(Ph₂POMe₂NPhenyl)₂ (3b), Cu₂I₂(Ph₂POMe₂NPhenyl)₂ (3c)**

Bei den Verbindungen 3a-c handelt es sich um feinkristalline Feststoffe.

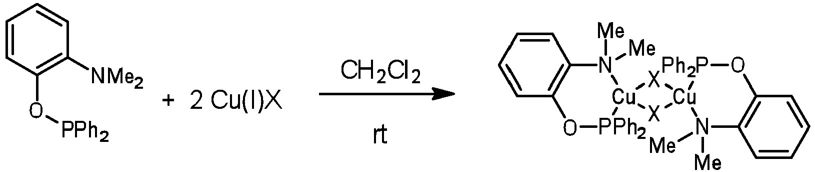

### IV. E∩D = Me₂NMe₂NBenzyl, X = Cl, Br, I: Cu₂Cl₂(Me₂NMe₂NBenzyl)₂ (4a), Cu₂Br₂(Me₂NMe₂NBenzyl)₂ (4b), Cu₂I₂(Me₂NMe₂NBenzyl)₂ (4c)

Bei den Verbindungen 4a-c handelt es sich um feinkristalline Feststoffe.

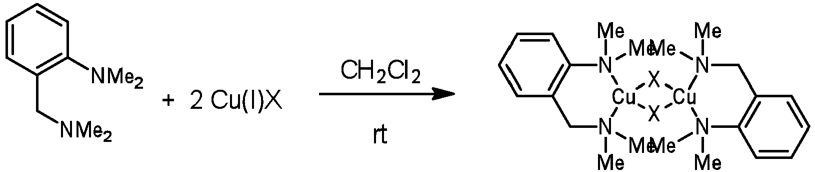

### V. E∩D = Ph₂PPh₂PBenzyl, X = Cl, Br, I: Cu₂Cl₂(Ph₂PPh₂PBenzyl)₂ (4a), Cu₂Br₂(Ph₂PPh₂PBenzyl)₂ (4b), Cu₂l₂(Ph₂PPh₂PBenzyl)₂ (4c)

Bei den Verbindungen 5a-c handelt es sich um feinkristalline Feststoffe.

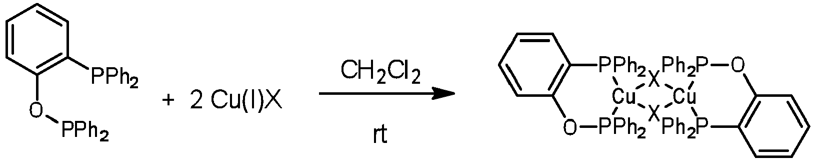

### VI. E∩D = PhSMe₂NBenzyl, X = Cl, Br, I: Cu₂Cl₂(PhSMe₂NBenzyl)₂ (6a), Cu₂Br₂(PhSMe₂NBenzyl)₂ (6b), Cu₂I₂(PhSMe₂NBenzyl)₂ (6c)

Bei den Verbindungen 6a-c handelt es sich um feinkristalline Feststoffe.

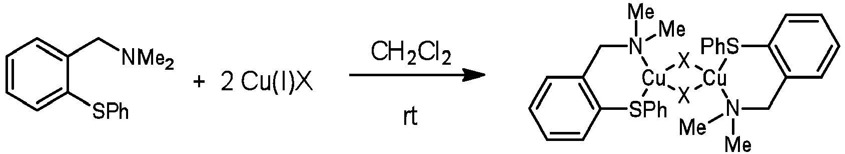

### VII. E∩D = Me₂NPhSBenzyl, X = Cl, Br, I: Cu₂Cl₂(Me₂NPhSBenzyl)₂ (7a), Cu₂Br₂(Me₂NPhSBenzyl)₂ (7b), Cu₂I₂(Me₂NPhSBenzyl)₂ (7c)

Bei den Verbindungen 7a-c handelt es sich um feinkristalline Feststoffe.

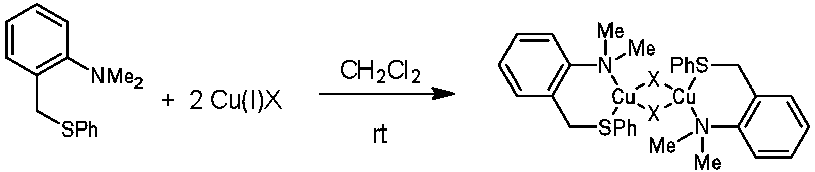

### VIII. E∩D = PhSPhSBenzyl, X = Cl, Br, I: Cu₂Cl₂(PhSPhSBenzyl)₂ (8a), Cu₂Br₂(PhSPhSBenzyl)₂ (8b), Cu₂I₂(PhSPhSBenzyl)₂ (8c)

Bei den Verbindungen 8a-c handelt es sich um feinkristalline Feststoffe.

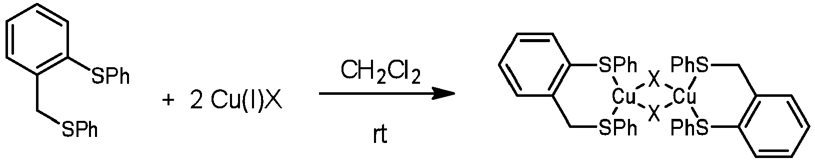

### IX. E∩D = Ph₂PNHCPhenyl, X = Cl, Br, I: Cu₂Cl₂(Ph₂PNHCPhenyl)₂ (9a), Cu₂Br₂(Ph₂PNHCPhenyl)₂ (9b), Cu₂I₂(Ph₂PNHCPhenyl)₂ (9c)

Bei den Verbindungen 9a-c handelt es sich um feinkristalline Feststoffe.

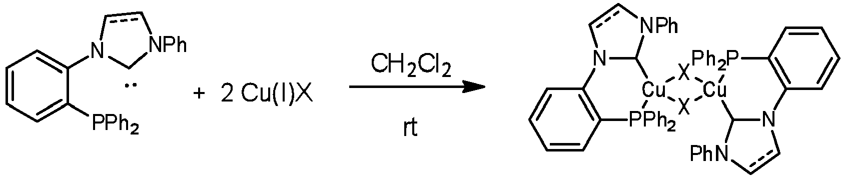

### X. E∩D = Me₂NNHCPhenyl, X = Cl, Br, I: Cu₂Cl₂(Me₂NNHCPhenyl)₂ (10a), Cu₂Br₂(Me₂NNHCPhenyl)₂ (10b), Cu₂I₂(Me₂NNHCPhenyl)₂ (10c)

Bei den Verbindungen **10a-c** handelt es sich um feinkristalline Feststoffe.

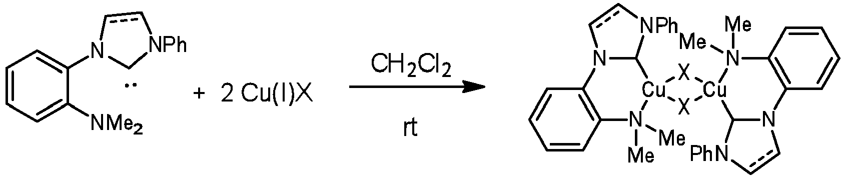

### XI. E∩D = PhSNHCPhenyl, X = Cl, Br, I: Cu₂Cl₂(PhSNHCPhenyl)₂ (11a), Cu₂Br₂(PhSNHCPhenyl)₂ (11b), Cu₂I₂(PhSNHCPhenyl)₂ (11c)

Bei den Verbindungen **11a-c** handelt es sich um feinkristalline Feststoffe.

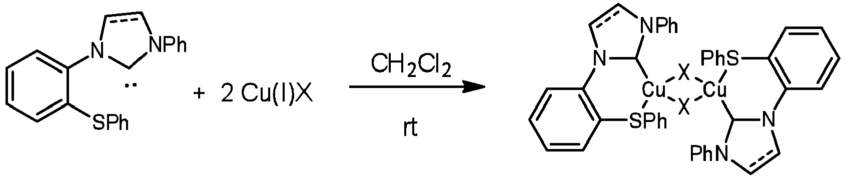

### XII. E∩D = Ph₂P(CH₂)₄NBenzyl, X = Cl, Br, I: Cu₂Cl₂(Ph₂P(CH₂)₄NBenzyl)₂ (12a), Cu₂Br₂(Ph₂P(CH₂)₄NBenzyl)₂ (12b), Cu₂I₂(Ph₂P(CH₂)₄NBenzyl)₂ (12c)

Bei den Verbindungen **12a-c** handelt es sich um feinkristalline Feststoffe.

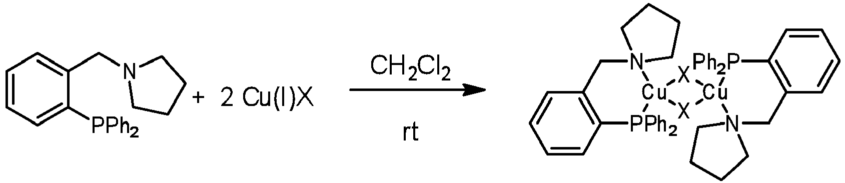

Die vorliegenden Verbindungen wurden mittels 1H und 31P NMR Spektroskopie charakterisiert und ihre Struktur durch Vergleich mit den durch Röntgenbeugung bestätigten, verwandten Strukturen **1a-c** bestimmt.
**12a:** ¹H-NMR (CDCl₃): 1.65 (bs, 4H, NCH₂CH₂), 2.45 (bs, 4H, NCH₂CH₂), 3.40 (bs, 2H,
   ArCH₂), 7.00 - 8.00 (m, 14H, Ar-H) ppm.
   ³¹P-NMR (CDCl₃): -22 ppm.
**12b:** ¹H-NMR (CDCl₃): 1.72 (bs, 4H, NCH₂CH₂), 2.53 (bs, 4H, NCH₂CH₂), 3.50 (bs, 2H,
   ArCH₂), 7.00 - 8.00 (m, 14H, Ar-H) ppm.
   ³¹P-NMR (CDCl₃): -20 ppm.
**12c:** ¹H-NMR (CDCl₃): 1.70 (bs, 4H, NCH₂CH₂), 2.52 (bs, 4H, NCH₂CH₂), 3.46 (bs, 2H,
   ArCH₂), 7.00 - 8.00 (m, 14H, Ar-H) ppm.
   ³¹P-NMR (CDCl₃): -16 ppm.

### Referenzen

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys. Lett. 2004, 84, 2476.
[iii] J. Shinar (Hrsg.), Organic light-emitting devices - A survey, AIP-Press, Springer, New York, 2004**.**
[iv] H. Yersin, Top. Curr. Chem. 2004, 241, 1.
[v] H. Yersin, Highly Efficient with Phosphorescent Materials, Wiley-VCH, Weinheim 2008**.**
[vi] Z. H. Kafafi, Organic Electroluminescence, Taylor & Francis, Boca Raton, 2005**.**
[vii] M. E. Thompson, P. I. Djurovich, J. Li (University of Southern California, Los Angeles, CA), WO 2004/017043 A2, 2004**.**
[viii] M. E. Thompson, P. I. Djurovich, R. Kwong (University of Southern California, Los Angeles, CA, Universal Display Corp, Ewing, NY), WO 2004/016711 A1, 2004**.**
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003**.**
[x] C.-M. Che, US 2003/0205707 A1, 2003**.**
[xi] C.-M. Che, W. Lu, M. C.-W. Chan, US 2002/0179885 A1, 2002**.**
[xii] J. Kamatani, S. Okada, A. Tsuboyama, T. Takiguchi, S. Igawa, US 2003/186080 A1, 2003**.**
[xiii] P. Stößel, I. Bach, A. Büsing (Covion Organic Semiconductors GmbH), DE 10350606 A1, 2005**.**
[xiv] M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005**.**
[xv] C. Lennartz, A. Vogler, V. Pawlowski (BASF AG), DE 10358665 A1, 2005**.**
[xvi] B. Hsieh, T. P. S. Thoms, J. P. Chen (Canon KK, Tokyo), US 2006/989273 B2, 2006**.**
[xvii]N. Schulte, S. Heun, I. Bach, P. Stoessel, K. Treacher (Covion Organic Semiconductors), WO 2006/003000 A1, 2006**.**
[xviii] A. Vogler, V. Pawlowski, H.-W. Schmidt, M. Thelakkat (BASF AG), WO 2006/032449 A1, 2006**.**
[xix] T. K. Hatwar, J. P. Spindler, R. H. Young (Eastman Kodak Co), WO 2006/028546 A1, 2006**.**
[xx] P. C. Ford, E. Cariati, J. Bourassa, Chem. Rev. 1999, 99, 3625.
[xxi] H. Araki, K. Tsuge, Y. Sasaki, S. Ishizaka, N. Kitamura, Inorg. Chem. 2007, 46, 10032.
[xxii] A. Rössler, G. Skillas, S. E. Pratsinis, Chemie in unserer Zeit 2001, 35, 32***.***
[xxiii] Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738.
[xxiv] Y. Chen, J. F. Gerald, L. T. Chadderton, L. Chaffron, Appl. Phys. Lett. 1999, 74, 2782.

## Patentansprüche

1. Metall(I)komplex aufweisend eine Struktur der Formel A 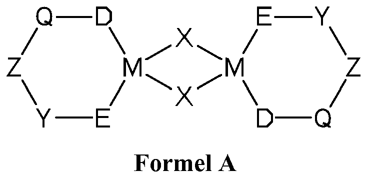 mit
M = unabhängig voneinander ausgewählt aus der Gruppe bestehend aus Cu und Ag;
X = unabhängig voneinander ausgewählt aus der Gruppe bestehend aus Cl, Br, I, CN, OCN, SCN, Alkinyl und N₃;
E∩D = unabhängig voneinander ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind.
wobei optional E∩D mindestens einen Substituenten zur Verbesserung des Ladungsträgertransports und/oder zur Erhöhung der Löslichkeit des Metall(I)komplexes in einem organischen Lösungsmittel aufweist.

2. Metall(I)komplex nach Anspruch 1, aufweisend eine Struktur der Formeln I bis IX 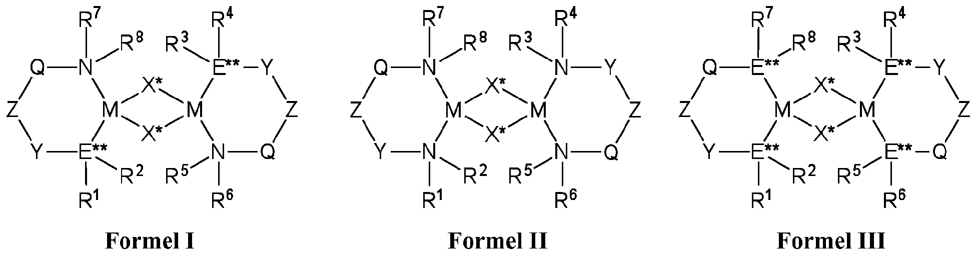 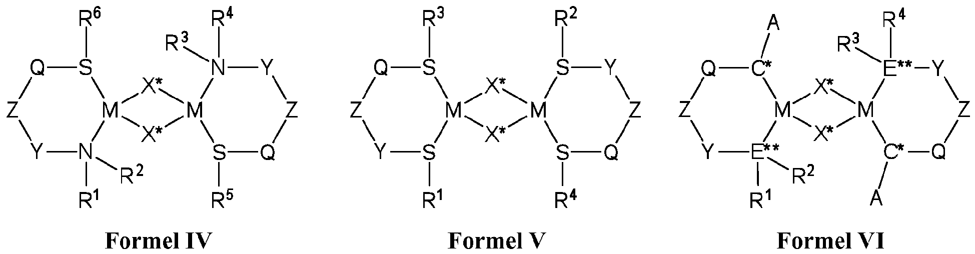 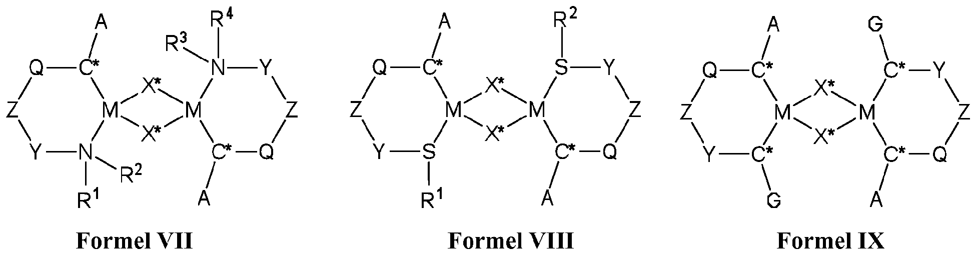 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl - und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei die Reste R¹-R⁸ optional zu annelierten Ringsystemen führen.

3. Metall(I)komplex nach Anspruch 1 oder 2, wobei die Einheit QC*A unabhängig voneinander ausgewählt ist aus der Gruppe bestehend aus 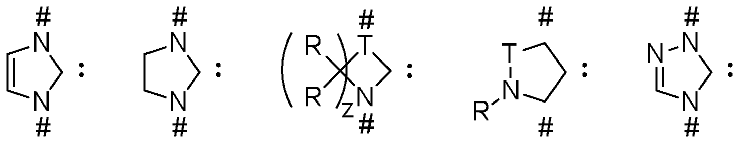 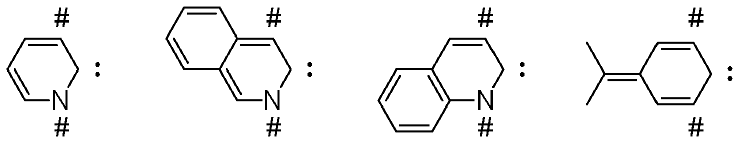 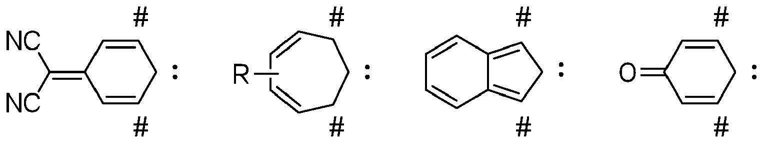 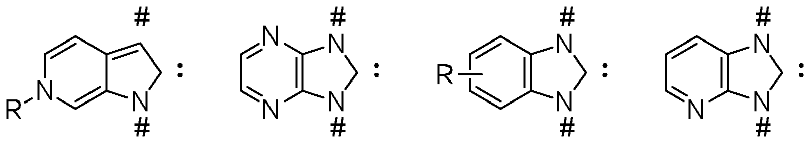 wobei
die zwei Punkte ":" für ein divalentes Carben-Kohlenstoffatom stehen, das an das Metall koordiniert, und die Verknüpfung von Q mit Z an einer der mit # gekennzeichneten Stellen stattfindet und somit A das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroaryl- Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
z für die ganzen Zahlen 1, 2, 3 oder 4 steht.

4. Metall(I)komplex nach Anspruch 1 bis 3, wobei E∩D unabhängig voneinander ausgewählt ist aus der Gruppe bestehend aus 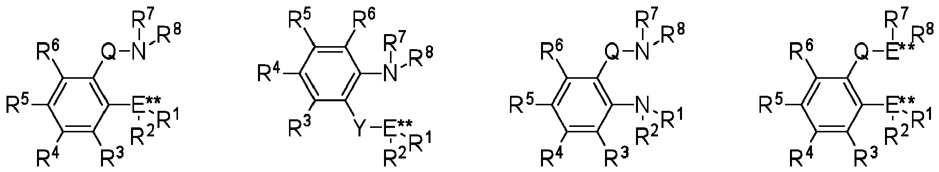 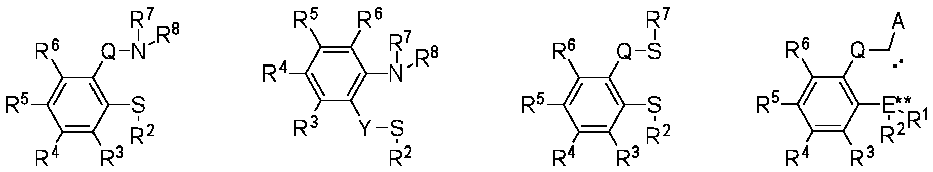 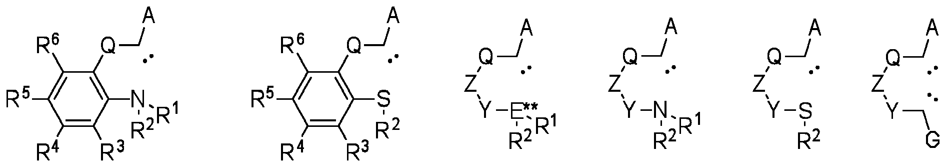 mit
E** = unabhängig voneinander ausgewählt aus der Gruppe bestehend aus P, As und Sb;
: = ein Carben-Kohlenstoffatom;
A und G = unabhängig voneinander Substituenten ausgewählt aus der Gruppe bestehend aus NRR', OR, SR und PRR' sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl - und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei A und Q und G und Y optional jeweils miteinander verbunden sind, sodass sich ein Imidazolidin- oder ein Imidazolderivat ausbildet und/oder mit der Einheit Z und/oder den Resten R³-R⁸ zu annelierten Ringsystemen führt;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl- und weitere allgemein bekannte Donor - und Akzeptor-Gruppen, wie beispielsweise Amine, Carboxylate und deren Ester, und CF₃-Gruppen, die optional weiter substituiert und/oder anneliert sind; wobei R³-R⁸ optional zu annelierten Ringsystemen führen.

5. Metall(I)komplex nach Anspruch 1 bis 4, wobei der Substituent zur Erhöhung der Löslichkeit ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

6. Metall(I)komplex nach Anspruch 1 bis 5, wobei der Substituent zur Verbesserung des Ladungsträgertransports ausgewählt ist aus der Gruppe bestehend aus Elektronenleiter und Lochleiter.

7. Verfahren zur Herstellung eines Metall(I)komplexes nach Anspruch 1 bis 6,
aufweisend den Schritt:
Durchführen einer Reaktion von E∩D mit M(I)X,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN,
Alkinyl und N₃;
E∩D = ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch), Heteroalkyl-, Aryl-, Heteroaryl und weitere allgemein bekannte Donor- und Akzeptor-Gruppen, wie beispielsweise Amine, Carboxylate und deren Ester, und CF₃-Gruppen, die optional weiter substituiert und/oder anneliert sind.

8. Verfahren nach Anspruch 7, wobei die Reaktion in Dichlormethan oder Acetonitril oder Tetrahydrofuran oder Dimethylsulfoxid oder Ethanol durchgeführt wird.

9. Verfahren nach Anspruch 7 oder 8, weiterhin aufweisend den Schritt der Zugabe von Diethylether, Pentan, Hexan, Methyl-tert-butylether, Methanol, Ethanol und/oder Wasser zur Gewinnung des Metall(I)komplexes in Form eines Feststoffs.

10. Verfahren nach Anspruch 7 bis 9, weiterhin aufweisend den Schritt der Substitution mindestens eines Liganden E∩D mit mindestens einem Substituenten zur Erhöhung der Löslichkeit, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

11. Verfahren nach Anspruch 7 bis 10, weiterhin aufweisend den Schritt der Substitution mindestens eines Liganden E∩D mit mindestens einer funktionellen Gruppe zur Verbesserung des Ladungsträgertransports, die ausgewählt ist aus Elektronenleiter und Lochleiter.

12. Verwendung eines Metall(I)komplexes nach Anspruch 1 bis 6 als Emitter oder Absorber in einem optoelektronischen Bauelement.

13. Verwendung nach Anspruch 12, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas - und Dampf-Sensoren,
- organischen Solarzellen,
- Organischen Feldeffekttransistoren,
- Organischen Lasern und
- Down-Konversions-Elementen.

14. Verwendung nach Anspruch 12 oder 13, **dadurch gekennzeichnet, dass** der Anteil des Metall(I)komplexes am Emitter oder Absorber 100 % beträgt.

15. Verwendung nach Anspruch 12 oder 13, **dadurch gekennzeichnet, dass** der Anteil des Metall(I)komplexes am Emitter oder Absorber 1 % bis 99 % beträgt.

16. Verwendung nach Anspruch 12 bis 15, **dadurch gekennzeichnet, dass** der Anteil des Metall(I)komplexes als Emitter in optischen Licht emittierenden Bauelementen, insbesondere in OLEDs, zwischen 5 % und 80 % beträgt.

17. Optoelektronisches Bauelement, aufweisend einen Metall(I)komplex nach Anspruch 1 bis 6.

18. Optoelektronisches Bauelement nach Anspruch 17, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Lichtemittierender elektrochemischer Zelle, organischem Feldeffekttransistor und organischem Laser.

19. Verfahren zur Herstellung eines optoelektronischen Bauelements, wobei ein Metall(I)komplex nach Anspruch 1 bis 6 verwendet wird.

20. Verfahren nach Anspruch 19, **gekennzeichnet durch** das Aufbringen eines Metall(I)komplexes nach Anspruch 1 bis 6 auf einen Träger.

21. Verfahren nach Anspruch 20, **dadurch gekennzeichnet, dass** das Aufbringen nass-chemisch, mittels kolloidaler Suspension oder mittels Sublimation erfolgt.

22. Verfahren zur Veränderung der Emissions- und/oder Absorptionseigenschaften eines elektronischen Bauelements, **gekennzeichnet durch** Einbringen eines Metall(I)komplexes nach Anspruch 1 bis 6 in ein Matrixmaterial zur Leitung von Elektronen oder Löchern in einem optoelektronischen Bauelement.

23. Verwendung eines Metall(I)komplexes nach Anspruch 1 bis 6, insbesondere in einem optoelektronischen Bauelement, zur Umwandlung von UV-Strahlung oder von blauem Licht in sichtbares Licht, insbesondere in grünes, gelbes oder rotes Licht (Down-Konversion).
